# EUROPEAN PATENT APPLICATION

(11) **EP 2 067 880 A1**
(43) Date of publication of application: **10.06.2009**
(21) Application number: 07830426.8
(22) Date of filing: 24.10.2007
(51) Int. Cl.: C23C 18/31, H01L 21/288

(54) **ELECTROLESS PLATING METHOD**

(30) Priority: 10.11.2006 JP 2006305738
(71) Applicant: S.E.S. Company Limited, Ome-shi, Tokyo 198-0023 (JP); Miyata, Seizo, Nishitokyo-shi, Tokyo 202-0004 (JP)
(72) Inventor: MIYATA, Seizo, Nishitokyo-shi Tokyo 202-0004 (JP); SHIMIZU, Tetsuya, Iruma-shi Saitama 358-0035 (JP); TAJIMA, Hisayoshi, Iruma-shi Saitama 358-0035 (JP); SONE, Masato, Koganei-shi Tokyo 184-0004 (JP)
(74) Representative: HOFFMANN EITLE
(86) International application number: PCT/JP2007/070692
(87) International publication number: WO 2008/056537

(57) **Abstract**

This invention provides an electroless plating method comprising electrolessly plating the surface of a metal base sample using a supercritical fluid or a subcritical fluid in such a state that a metal powder is dispersed in an electroless plating liquid. According to this method, a homogeneous and thick plating layer is formed in a short time by taking advantage of an induction eutectoid phenomenon. In the electroless plating method, the metal powder may have an average particle diameter of not less than 1 nm and not more than 100 &mgr;m, and the electroless plating method may also be applied to a damascene process or a dual damascene process which is a method for forming a fine metal wiring within a semiconductor element. The above constitution can provide an electroless plating method which can realize the formation of an even film by electroless plating in a short time using a subcritical fluid or a supercritical fluid by taking advantage of an induction eutectoid phenomenon.

## Description

### TECHNICAL FIELD

The present invention relates to an electroless plating method for forming an electroless plating on a surface of a metal base, and particularly relates to an electroless plating method in which a uniform film can be obtained by electroless plating in a short time using an induction eutectoid phenomenon in the presence of a subcritical fluid or supercritical fluid.

### BACKGROUND ART

In conventional methods for forming a fine metal wiring within a semiconductor element, a thin aluminum film is formed, for example, on a substrate by sputtering, a photoresist is then applied, a pattern is formed by exposure and development, and a designated wiring is formed by etching. However, such wiring methods have come to be difficult to use with the progress in the increased integration and miniaturization of semiconductor circuit elements, prompting wider use of so-called Damascene methods, in which a wiring groove or hole is formed in advance; aluminum is embedded in the groove or hole by chemical vapor deposition (CVD), sputtering, plating, or another method; and the surface is then polished by chemical mechanical polishing (CMP) to form a wiring. One of the Damascene methods, referred to as the dual Damascene method, is one in which a hole for connecting the bottom layer to the wiring is formed at the time the groove is formed, the connecting hole and groove are filled with aluminum or copper at the same time, and a wiring is formed.

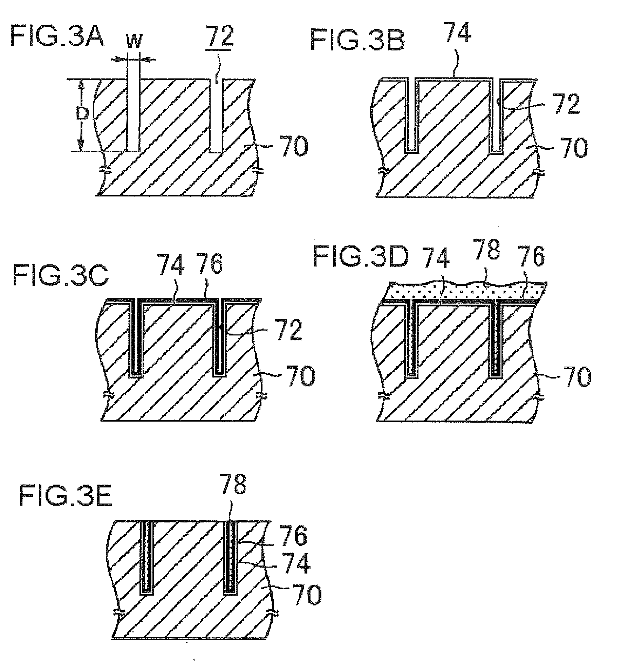

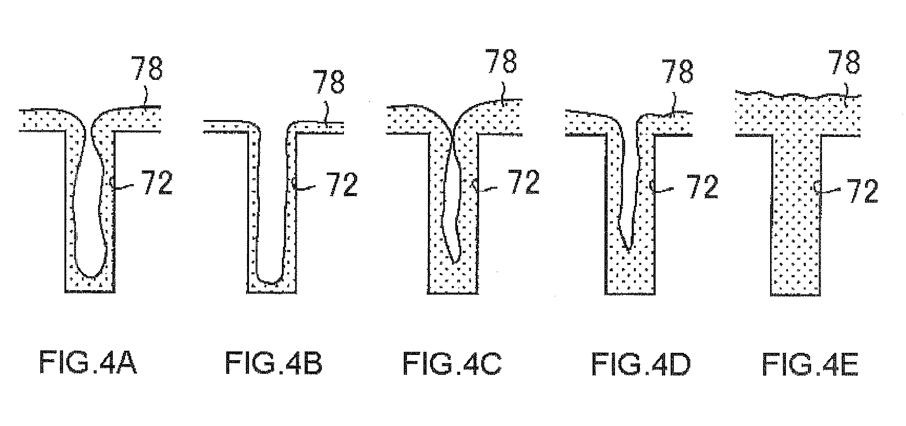

A Damascene method in which electroplating is used has recently become popular as a step for forming wiring in a semiconductor device (see Patent Documents 1 and 2 below). Following is a description, made with reference to FIGS. 3 and 4, of a method for forming a wiring in a semiconductor device for three-dimensional mounting by using the Damascene method disclosed as a prior-art example in Patent Document 1. In this wiring method, a hole 72 is formed, for example, by lithography or etching in the surface of a silicon substrate or other substrate 70, as shown in FIG. 3A; an insulating film 74 composed of SiO₂ is subsequently formed, for example, by CVD on the surface of the substrate 70, as shown in FIG. 3B; the surface of the hole 72 is covered with the insulating film 74 to thereby prevent leakage of electricity; and a seed layer 76 is further formed, for example, by CVD or sputtering as an electroplating feeder layer on the insulating film 74, as shown in FIG. 3C.

The surface of the substrate 70 is electroplated with copper as shown in FIG. 3D, the interior of the hole 72 in the substrate 70 is filled with copper, a copper plating film 78 is deposited on the insulating film 74, the copper plating film 78 and the insulating film 74 are then removed from the substrate 70 by CMP as shown in FIG. 3E, and the surface of the copper plating film 78 in the hole 72 is made substantially coplanar with the surface of the substrate 70 to form an embedded wiring.

In the embedded wiring disclosed in Patent Document 1, the diameter W of the hole 72 is about 5 to 20 µm, and the wiring is applicable to cases in which the depth D is about 50 to 70 µm. In the step in which copper is electroplated in the manner shown in FIG. 3D according to the invention disclosed in Patent Document 1, a step is added in which part of the plating film is etched during the electroplating step, as shown in FIG. 4B, in order to prevent situations in which the copper creates an overhang in proximity to the entrance to the hole 72, as shown in FIG. 4A, and voids (air holes) are formed inside the copper wiring. The groove 72 is filled with copper 78, as shown in FIG. 4E, by further repeating the electroplating step and the plating film etching step the desired number of times, as shown in FIGS. 4C and 4D.

Thus, using inventions such as the one disclosed in Patent Document 1 makes it difficult to fill copper without voids into a narrow groove or hole that measures about 0.20 µm or less. Therefore, this problem is solved in the invention disclosed in Patent Document 2 below by adjusting the composition of the plating solution and adjusting the metal deposition rate at the bottom and entrance of the groove or hole.

Patent Document 1: Japanese Laid-Open Patent Application No. 2003-96596
Patent Document 2: Japanese Laid-Open Patent Application No. 2005-259959
Patent Document 3: Japanese Laid-Open Patent Application No. 10-245683
Patent Document 4: Japanese Laid-Open Patent Application No. 2006-37188

### DISCLOSURE OF THE INVENTION

### [Problems the Invention Is Intended to Solve]

A method for forming fine metal wiring by an electroplating method such as the one described above is an effective method because it allows for the easy formation of feeder terminals in cases in which a seed layer 76 can easily be formed as a feeder layer, but forming feeder terminals is difficult when the plating portion is small or when it is necessary to plate the interior or the like of a groove or hole whose depth is greater than the size of the opening. Therefore, an electroless plating method is adopted.

The electroless plating method has been adopted in a wide range of fields because the resulting plating layers are dense, very small areas can be plated, and the surface of insulators can be plated as well. However, the deposition rate of the plating layer is low, making it difficult to immediately apply such a method to a Damascene method or dual Damascene method such as those described above, in which a thick metal layer must be formed.

Patent Document 3 discloses a method in which a tin or tin alloy plating bath containing powder, which forms an alloy with tin and functions as a soldering film, is used to form a thick tin alloy film by the electroless plating method. However, the characteristics of the plating film itself are not satisfactory, and adhesion to the underlayer is compromised with such an electroless plating method, making this method difficult to adopt in general applications despite the fact that the method is effective in applications in which solder films are involved and heat treatments are performed, as in the method disclosed in Patent Document 3 described above.

Patent Document 4 described above discloses an electroless plating method comprising the steps of: degreasing and etching the surface of a base material by bringing the material into contact with a subcritical fluid or a supercritical fluid obtained by dissolving a metal complex containing the same metal as the plating metal; supporting the metal complex on the surface of the base material and reducing the metal complex supported on the surface of the base material to deposit the metal contained in the metal complex onto the surface of the base material and to form metal nuclei; and immersing the base material whose surface is provided with the metal nuclei into a plating solution containing the plating metal to continuously maintain the deposition reaction and to form a plating layer by using the metal nuclei in their unmodified form as an autocatalyst.

Similar to the conventional electroless plating method, however, immediately applying the electroless plating method disclosed in Patent Document 4 described above is also difficult for a Damascene method or dual Damascene method such as those described above, that is, a method in which a thick metal layer must be formed, because of the low deposition rate of plating layers.

As a result of repeated experiments conducted to obtain an electroless plating method in which the plating layer has a high deposition rate and improved adhesion to the underlying metal base, the inventors completed the present invention upon discovering that by adding a fine metal powder, with the powder being the same as at least one of a metal base and a metal film obtained by electroless plating, to the electroless plating solution in advance in large amounts, and performing electroless plating using a subcritical fluid or a supercritical fluid, it is possible to incorporate the fine metal powder into the plating layer and to form a thick uniform plating film in a short time by using the induction eutectoid phenomenon.

Namely, an object of the present invention is to provide an electroless plating method wherein the plating layer has a high deposition rate, adhesion to the underlying metal base is improved, and a thick uniform plating film can be obtained in a short time.

### [Means for Solving the Abovementioned Problems]

Aimed at achieving the aforementioned object, the electroless plating method of the present invention is a method for forming an electroless plating on a surface of a metal base, the electroless plating method characterized in comprising: performing electroless plating by utilizing an induction eutectoid phenomenon using a subcritical fluid or supercritical fluid in a state in which metal powder is dispersed in an electroless plating solution. In the present specification, "induction eutectoid phenomenon" refers to a phenomenon in which a portion of metal powder is also simultaneously incorporated into the plating layer during electroless plating.

According to the electroless plating method of the present invention described above, electroless plating is performed in the presence of a subcritical fluid or a supercritical fluid in a state in which metal powder is dispersed in an electroless plating solution during formation of an electroless plating on the surface of a metal base. Therefore, fine metal powder is incorporated into the plating layer, and a thick uniform plating film can be obtained in a short time by using the induction eutectoid phenomenon. For this reason, the electroless plating method can be effectively used, particularly in a Damascene method, dual Damascene method, and other applications in which fine metal wiring is formed in highly integrated, miniaturized semiconductor circuit elements.

The electroless plating method of the present invention is also characterized in that the metal powder comprises the same metal as at least one of the metal base and a metal film obtained by electroless plating.

The electroless plating method of the present invention is also characterized in that the average particle diameter of the metal powder is from 1 nm or greater to 100 µm or less.

According to the electroless plating method of the present invention as described above, the average particle diameter of the metal powder is set to a range of from 1 nm or greater to 100 µm or less. Therefore, the metal powder can be easily dispersed into the electrolytic solution, not only making aggregation more difficult, but also allowing electroless plating to be easily performed in microstructures having a precision of less than 100 µm. The average particle diameter of the metal powder used is preferably less than the dimensions of the microstructure involved in electroless plating.

The electroless plating method of the present invention is also characterized in that the electroless plating is conducted in the combined presence of at least one of carbon dioxide and an inert gas, as well as a surfactant.

According to the electroless plating method of the invention described above, the electroless plating is conducted in the combined presence of at least one of carbon dioxide and an inert gas, as well as the electroless plating solution and surfactant, by using a subcritical fluid or supercritical fluid. Therefore, the electroless plating solution and the metal base are brought into contact with each other in an emulsified state. For this reason, the electroless plating solution rapidly penetrates into fine holes and grooves, and electroless plating can therefore be efficiently performed on a metal base that has a complex shape as well as in applications in which a fine metal wiring is formed in highly integrated, miniaturized semiconductor circuit elements.

### BRIER DESCRIPTION OF THE DRAWINGS

FIG. 1 is a schematic view of an electroless plating device used in the experimental examples;
FIG. 2 is a timing flow chart of the pressure-resistant electroless plating chamber employed when electroless plating is conducted using a supercritical fluid or a subcritical fluid;
FIG. 3A through 3E are views showing steps for forming wiring in a semiconductor device for three-dimensional mounting in a prior-art example; and
FIG. 4 is a view showing the void suppression step employed by the prior art shown in FIG. 3.

### [Key to Symbols]

- 10: electroless plating device
- 11: pressure-resistant electroless plating chamber
- 12: carbon dioxide cylinder
- 13: high-pressure pump unit
- 14: valve
- 15: lid
- 16: entrance
- 17: exit
- 18: pressure adjustment unit
- 19: electroless plating solution
- 20: stirrer
- 21: oven
- 22: metal base sample

### BEST MODE FOR CARRYING OUT THE INVENTION

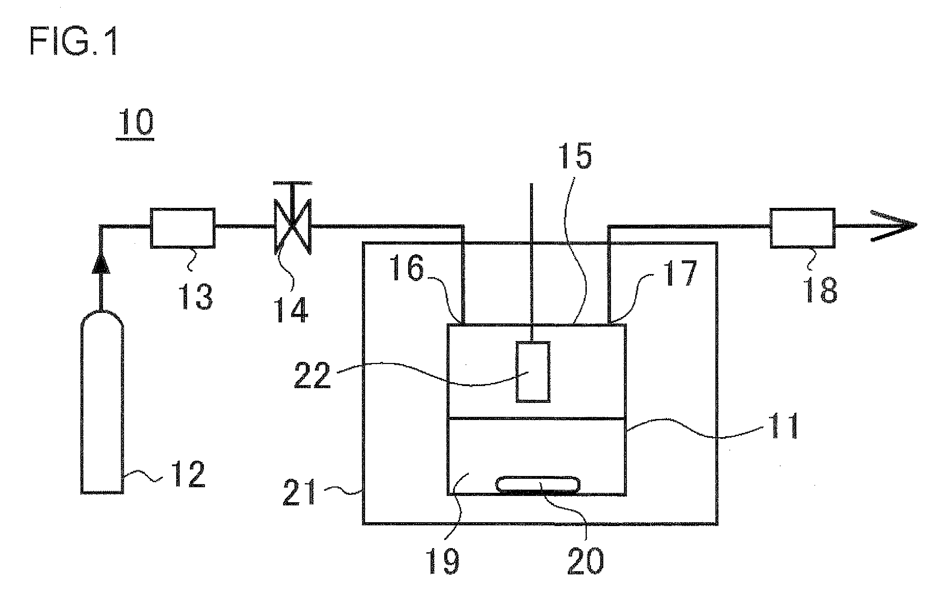

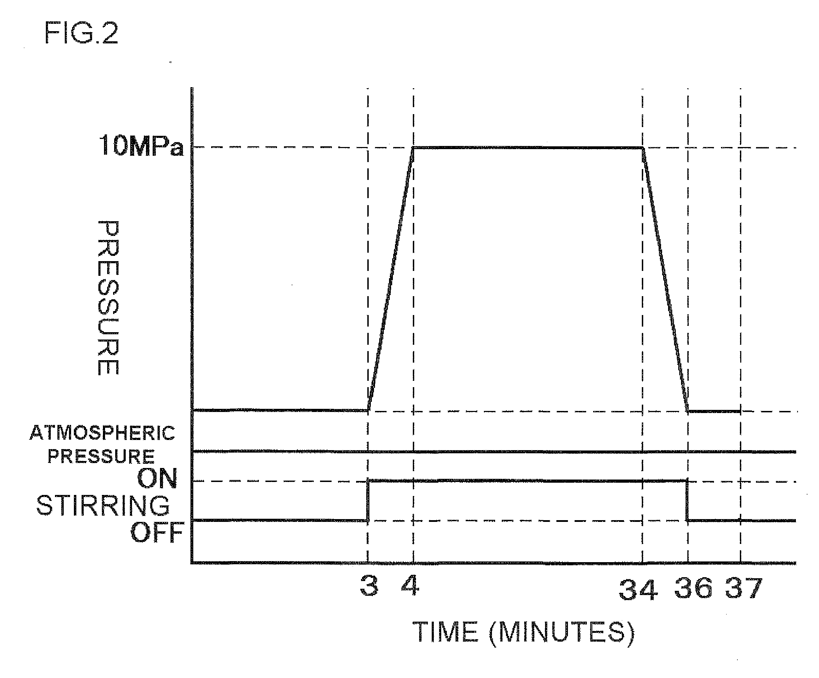

Preferred embodiments for implementing the present invention will be described in detail hereinafter with reference to the experimental examples and the drawings, but the experimental examples described below are not intended to limit the present invention to those described herein, and the present invention is equally applicable to various modifications that do not depart from the technical spirit described in the claims. FIG. 1 is a schematic view of an electroless plating device used in the experimental examples; and FIG. 2 is a timing flow chart of the pressure resistant electroless plating chamber 11 employed when electroless plating is conducted using a supercritical fluid or a subcritical fluid.

### [Electroless Plating Solution]

A commercial-grade nickel-phosphorus electroless plating solution (Top Nicoron VS (product name), made by Okuno Chemical Industries Co., Ltd.) was used as an electroless plating solution in the experimental examples described below. The nickel-phosphorus electroless plating solution had a nickel concentration of 5.5 g/L and a pH of 5.4. An aqueous solution of a palladium chloride activator (ICP Accera (product name), made by Okuno Chemical Industries Co., Ltd.) was used as a catalyst. A nonionic surfactant was added to the electroless plating solution in a concentration of 10 mL/L. When nickel powder was added, the powder had a particle diameter of 3 to 7 µm and was added in an amount of 0.3 g/L to 500 mL of the plating solution.

### [Electroless Plating Apparatus]

A pressure-resistant electroless plating chamber 11 was used in an electroless plating apparatus 10 in order to allow electroless plating to be performed using a supercritical fluid or subcritical fluid, as shown in FIG. 1. Carbon dioxide can be fed as necessary from a carbon dioxide cylinder 12 through a high-pressure pump unit 13 and a valve 14 to the entrance 16 provided to a top lid 15 in the pressure-resistant electroless plating chamber 11. The carbon dioxide can also be released into the surrounding atmosphere through a pressure adjustment unit 18 from an exit 17 provided in the top lid 15.

In the pressure-resistant electroless plating chamber 11, removing the lid 15 allows a predetermined amount of electroless plating solution 19 to be injected into the chamber, a stirrer 20 is inserted as stirring means into the pressure-resistant electroless plating chamber 11, and the pressure-resistant electroless plating chamber 11 is configured so as to be placed inside an oven 21 and to allow the electroless plating solution 19 inside the chamber to be kept at a constant temperature. To conduct a measurement at atmospheric pressure, the carbon dioxide cylinder 12, high-pressure pump unit 13, valve 14, and pressure adjustment unit 18 are operated to open the interior of the pressure-resistant electroless chamber 11 to atmospheric pressure. The metal base sample 22 is held from the upper part of the pressure-resistant electroless plating chamber 11 and is immersed from the outside as needed into the electroless plating solution 19.

### [Metal Base]

The metal base used in the experimental examples was a metal base sample 22 obtained in the following manner: commercial-grade brass was used, this metal base was pretreated by acid pickling, and the surface of the base was activated by immersing the base into the above-described aqueous solution of a palladium chloride activator as the catalyst for 3 minutes at 25°C.

### [Experimental Examples 1 and 2]

In Experimental Examples 1 and 2, electroless plating was conducted in a supercritical or subcritical state when nickel powder was added (Experimental Example 1) and when nickel powder was not added (Experimental Example 2). First, 30 mL of the designated electroless plating solution 19 was injected into the pressure resistant electroless plating chamber 11, and the metal base sample 22 was placed in the upper part of the electroless plating solution 19 in the pressure-resistant electroless plating chamber 11 so as not to be in contact with the electroplating solution 19. In this state, the electroless plating solution in the pressure-resistant electroless plating chamber 11 was heated to a temperature of 80°C; stirring with the stirrer 20 in the electroless plating solution 19 was started (at a constant stirring rate of 300 rpm); and the carbon dioxide cylinder 12, the high-pressure pump unit 13, the valve 14, and the pressure adjustment unit 18 were manually operated to increase the pressure inside the pressure-resistant electroless plating chamber 11 to 10 MPa.

When this was done, the critical temperature of the carbon dioxide was 31.1°C, and the critical pressure was 7.38 MPa. Therefore, the interior of the pressure-resistant electroless plating chamber 11 was substantially in a supercritical or subcritical state under the abovementioned temperature and pressure conditions. In addition, the electroless plating solution 19 was substantially in an emulsified state due to the surfactant contained in the electroless plating solution 19, and the electroless plating solution 19 in the emulsified state was poured into the pressure-resistant electroless plating chamber 11 and brought into adequate contact with the metal base sample 22.

A reduction in the pressure of the pressure-resistant electroless plating chamber 11 was started 30 minutes after the pressure in the pressure-resistant electroless plating chamber 11 reached 10 MPa; the stirring of the electroless plating solution 19 was stopped when the pressure inside the pressure-resistant electroless plating chamber returned to atmospheric pressure; the lid 15 was removed; the metal base sample 22 was taken out, rinsed, and dried; and the metal base sample 22 was then visually inspected to evaluate the state of the plating on the surface of the sample. FIG. 2 shows a timing flow chart of the pressure-resistant electroless plating chamber 11 in Experimental Examples 1 and 2. The measurement results obtained in Experimental Examples 1 and 2 are shown in Table 1.

The measurement results were evaluated according to the four categories described below.
○: A sufficiently thick plating film was obtained.
△: A sufficient plating film was obtained, but the film was thin.
▲: A plating film was obtained, but the film was thin and was found to have partial irregularities.
×: The plating film was found to be thin and to have irregularities across the entire surface.

### [Experimental Examples 3 and 4]

In Experimental Examples 3 and 4, electroless plating was conducted at atmospheric pressure in a case in which nickel powder was added (Experimental Example 3) and in a case in which nickel powder was not added (Experimental Example 4). First, 40 mL of a designated electroless plating solution 19 was injected into the pressure-resistant electroless plating chamber 11 that was open to the atmosphere. In this state, the electroless plating solution in the pressure-resistant electroless plating chamber 11 was heated to a temperature of 80°C; stirring with the stirrer 20 in the electroless plating solution 19 was started (at a constant stirring rate of 300 rpm); and the metal base sample 22 was immersed into the electroless plating solution 19. This state was maintained for 30 minutes; the metal base sample 22 was taken out, rinsed, and dried; and the metal base sample 22 was then visually inspected to evaluate the state of the plating on the surface of the sample. The measurement results obtained from Experimental Examples 3 and 4 are summarized in Table 1 along with the measurement results for Experimental Examples 1 and 2.

**[Table 1]**

| | Ni powder present? | Pressure | Plating state |
|---|---|---|---|
| Experimental Example 1 | Yes | 10 MPa | ○ |
| Experimental Example 2 | No | 10 MPa | △ |
| Experimental Example 3 | Yes | Atmospheric | ▲ |
| Experimental Example 4 | No | Atmospheric | × |

The following can be understood from the results described in Table 1. Namely, the plating film was thin and was found to have irregularities across the entire surface in the case of Experimental Example 4 in which no nickel powder was added to the electroless plating solution when conducting electroless plating at atmospheric pressure. A plating film was obtained, but the film was thin and was found to have partial irregularities in the case of Experimental Example 3 in which nickel powder was added to the electroless plating solution. The electroless plating solution used in Experimental Examples 3 and 4 was an electroless plating solution commonly used in the prior art. Because of a low deposition rate, it was confirmed that the electroless plating of 30 minutes was insufficient as the plating time, and irregularities were observed. In addiction, more suitable results were obtained in Experimental Example 3, in which nickel powder was added to the electroless plating solution, than in Experimental Example 4, in which nickel powder was not added. Therefore, adding nickel powder was found to have the effect of improving the rate at which the plating layer was deposited even when electroless plating was conducted at atmospheric pressure.

In the case of Experimental Example 2, in which no nickel powder was added to the electroless plating solution and electroless plating was conducted in a supercritical or subcritical state, a sufficient plating film was obtained, but the plating film was thin. However, a sufficiently thick plating film was obtained in the case of Experimental Example 1, in which nickel powder was added to the electroless plating solution. From these results, electroless plating was found to have the effect of improving the rate at which the plating layer was deposited even when nickel powder was not added during electroless plating in a supercritical or subcritical state, but partial irregularities were found to occur because 30 minutes was still not enough time to conduct electroless plating. Because the deposition rate of the plating layer was high in the case of Experimental Example 1, in which nickel powder was added to the electroless plating solution, a sufficiently thick plating layer was formed without any irregularities during 30-minute electroless plating.

It is apparent from the above results that when a powder of the plating metal is added to the electroless plating solution in advance during electroless plating in a supercritical or subcritical state, a thick, adequate plating layer can be obtained, and the process can be applied to the Damascene or dual Damascene method because of the improvement in the deposition rate of the plating layer.

Although particles having a diameter of 3 µm to 7 µm were used as nickel powder in the experiment examples described above, a smaller particle diameter is preferred in order to allow fast and dense plating to occur in narrow locations because the nickel powder is incorporated into the plating layer at the same time as the plating layer is being deposited from the electroless plating solution by the induction eutectoid phenomenon, and the powder is linked to the improvement in the deposition rate of the plating layer during electroless plating. In particular, because nickel disperses well and aggregates less readily in an electrolytic solution when particles of 1µm or less are used, electroless plating can also easily be performed on substrate structures whose precision is less than 1 µm. Obtaining fine metal powder in which the metal has an average particle diameter of less than 1 nm is difficult at the present time, but an average particle diameter of about 1 nm is realistic.

The above experimental examples described cases in which the metal used in the metal base was brass and the electroless plating metal was nickel, but the electroless plating method of the present invention has the same effect whether the metal base and electroless plating metal are of the same type or are or different types. Not only brass and nickel, but also copper, zinc, iron, nickel, cobalt, and the like are equally applicable as the metal base and electroless plating metal.

## Claims

1. A method for forming an electroless plating on a surface of a metal base, the electroless plating method **characterized in** comprising: performing electroless plating by utilizing an induction eutectoid phenomenon using a subcritical fluid or supercritical fluid in a state in which metal powder is dispersed in an electroless plating solution.

2. The electroless plating method according to claim 1, **characterized in that** said metal powder comprises the same metal as at least one of the metal base and a metal film obtained in electroless plating.

3. The electroless plating method according to claim 1, **characterized in that** the average particle diameter of said metal powder is from 1 nm or greater to 100 µm or less.

4. The electroless plating method according to claim 1, **characterized in that** the electroless plating is conducted in the combined presence of at least one of carbon dioxide and an inert gas, as well as a surfactant.
